# EUROPEAN PATENT APPLICATION

(11) **EP 0 790 533 A2**
(43) Date of publication of application: **20.08.1997**
(21) Application number: 97300845.1
(22) Date of filing: 10.02.1997
(51) Int. Cl.: G03F 7/42

(54) **Process and apparatus for surface cleaning**

(30) Priority: 16.02.1996 GB 9603295
(71) Applicant: The BOC Group plc, Windlesham Surrey GU20 6HJ (GB)
(72) Inventor: Thwaites, Michael John, Basingstoke, Hampshire RG27 9PF (GB)
(74) Representative: Bousfield, Roger James

(57) **Abstract**

A method of removing separate metal (4) and photo-resist coatings from a surface or surfaces of an article which comprises:
- treating the photo-resist coating to an oxygen and/or carbon tetrafluoride plasma in an evacuated chamber (1), and
- treating the metal coating (4) to an inert gas plasma in an evacuated chamber (1) not containing oxygen and/or carbon tetrafluoride
and wherein, if the metal coating treatment occurs first, the photo-resist coating is protected by means of an earth shield (7).

## Description

This invention relates to processes and apparatus for the cleaning of surfaces, in particular those surfaces having thereon unwanted coatings of other substances, for example glass disc substrates used in the manufacture of compact discs.

In the manufacturing process for audio, video or ROM compact disc, it is common for a master disc to be employed on to which a recording pattern is formed and from which a stamper for the production of individual compact discs are made.

The master disc generally is made of a high grade glass material on to a surface of which the recording pattern is formed by means of deposition of a thin coating of a photo-resist material. The photo-resist material is then coated with a thin, for example 0.1 µm, coating of a nickel-vanadium alloy (93% Ni:7% vanadium by weight) which conforms to the recording pattern of the photo-resist and generally fills the holes/indentations in the photo-resist material. The nickel-vanadium alloy coating is subsequently coated with a relatively thick, for example 300µm, layer of nickel.

In order to proceed with the manufacture of a stamper by means known generally per se, and which need not be described in this specification, the glass disc bearing the photo-resist material layer is separated from the nickel-vanadium alloy and nicke layers. This separation leaves the glass disc not only with the photo-resist layer firmly adhering thereto but also a peripheral ring of nickel-vanadium alloy on the same side of the disc as that bearing the photo-resist layer.

The high value of the glass means that it is imperative for the nickel-vanadium peripheral layer and the photo-resist material to be clearly removed to enable the glass disc to be used for the production of subsequent stampers for the different compact discs.

Known methods for removing these coatings are extremely slow and generally involve the use of separate chemicals which slowly dissolve the respective coatings over, for example, a period of twelve hours for the photo-resist and three hours for the nickel-vanadium alloy.

The invention provides a method for removing metal and photo-resist coatings from a surface such as those described above involving the use of a plasma.

In accordance with the invention, there is provided a method of removing separate metal and photo-resist coatings from a surface or surfaces of an article which comprises:
- treating the photo-resist coating to an oxygen and/or carbon tetrafluoride plasma in an evacuated chamber, and
- treating the metal coating to an inert gas plasma in an evacuated chamber not containing oxygen and/or carbon tetrafluoride
and wherein, if the metal coating treatment occurs first, the photo-resist coating is protected by means of an earth shield.

The inert gas plasma is preferably formed from argon but may also be formed from other inert or noble gases including xenon and krypton.

It is generally preferably for the metal coating treatment to be effected first in the inert gas plasma and then be followed by the photo-resist coating treatment as it is simpler to add the required oxygen and/or carbon tetrafluoride to the evacuated chamber in the second treatment.

It is commonly important, and is usually essential in the case of high grade glass articles to be cleaned, that the part of the surface(s) not bearing a coating is protected during the treatment. As in the case of the protection of the photo-resist coating if the metal coating treatment is performed first, this can usefully be achieved by use of an earth shield.

The argon or other inert gas plasma can be formed in the chamber by any useful means including the formation of plasma glow discharge between two electrodes in a manner known per se. Preferably, however, a radio frequency, for example 13.56 MHz, is employed to form an argon plasma and this can usefully be applied to a holder or support for the article from which the coatings are to be removed.

The pressure in the chamber in the presence of argon can usefully be in the range of 10⁻¹ to 10⁻³ mbar.

The pressure in the chamber in the presence of oxygen and/or carbon tetrafluoride can usefully be in the range of 10⁻¹ to 10⁻³ mbar.

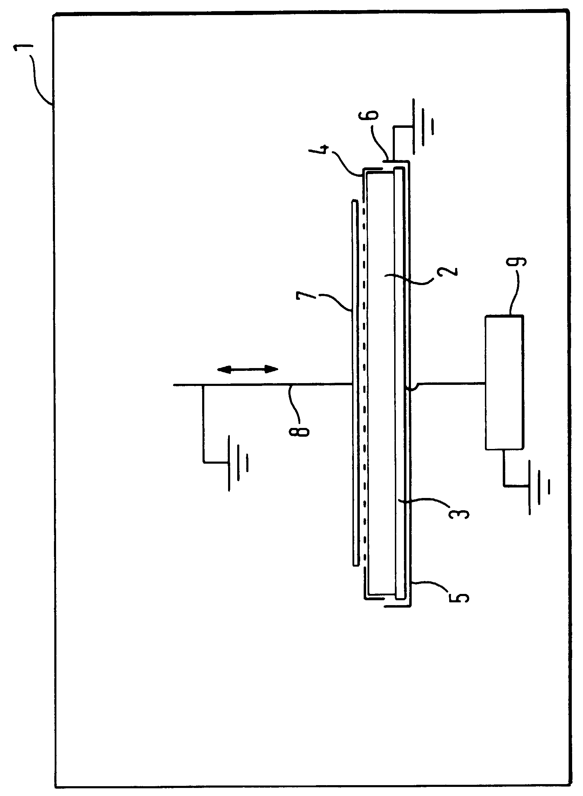

For a better understanding of the invention, reference will now be made, by way of exemplification only, to the accompanying drawing which shows in a schematic manner, apparatus for performing the method of the invention.

With reference to the drawing, there is shown apparatus for performing the method of the invention within a vacuum chamber 1.

A circular glass disc 2 of high grade material is supported within the chamber 1 by a cathode 3 of slightly larger diameter than the disc 2; the cathode 3 is also supported within the chamber 1 by means not shown.

The glass disc 2 is shown as bearing a nickel-vanadium coating 4 about a peripheral edge of the upper (as shown) surface of the disc 2 and extended approximately half way down the curved vertical surface of the disc 2. The disc 2 is also shown by means of dotted lines as bearing a photo-resist coating across substantially all of the upper (as shown) surface.

A first circular earth shield 5 is positioned by means not shown in close proximity to the cathode 3 with an upstanding edge 6 extending up to the lowermost edge of the nickel-vanadium coating 4.

A second circular earth shield 7 is also positioned in the chamber and supported therein by a rod 8 which is movable in a vertical direction as shown by the arrows to raise and lower the second earth shield 7 during operation of the method.

In operation of the method, the chamber 1 is evacuated down to 10⁻⁴ mbar and 10 sccm (standard cubic centimetres per minute) of argon is introduced.

A radio frequency (rf) is applied to the cathode 3 from the power supply 9 at 13.56 MHz and this causes an argon plasma to be formed in the chamber 1.

In a first part of the method, the earth shield 7 is positioned at its lowest point as shown in the drawing to form a substantially uniform gap between the top (as shown) surface of the glass disc 2 and the lower surface of the shield 7 of no more than about 3mm. Such a gap represents the "Crookes Dark Space" in which no argon ionisation will occur and thereby allows the shield 7 to "protect" the photo-resist coating during the first part of the process.

The argon ions present in the plasma formed in the chamber therefor bombards the exposed nickel vanadium alloy and the alloy coating is sputtered from the surface of the glass disc 2.

In a second part of the method argon is removed from the chamber and oxygen gas, for example 10 sccm and 1 sccm of carbon tetrafluoride is introduced in to the chamber and the earth shield 7 is raised from its proximity to the disc 2 in the direction shown by the arrows.

In this part of the method, the photo-resist coating is removed from the glass disc 2 without in general affecting the surface quality of the high grade glass which is therefore reusable.

## Claims

1. A method of removing separate metal and photo-resist coatings from a surface or surfaces of an article which comprises:
- treating the photo-resist coating to an oxygen and/or carbon tetrafluoride plasma in an evacuated chamber, and
- treating the metal coating to an inert gas plasma in an evacuated chamber not containing oxygen and/or carbon tetrafluoride
and wherein, if the metal coating treatment occurs first, the photo-resist coating is protected by means of an earth shield.

2. A method according to Claim 1 in which the inert gas plasma is formed from argon.

3. A method according to Claim 1 or Claim 2 in which the metal coating treatment is effected first.
